Europäisches Patentamt

**European Patent Office**

Office européen des brevets

(19)

(11) Numéro de publication : **0 002 990 B1**

(12) **FASCICULE DE BREVET EUROPÉEN**

(45) Date de publication du fascicule du brevet :
15.12.82

(21) Numéro de dépôt : 78400255.2

(22) Date de dépôt : 21.12.78

(51) Int. Cl.³ : **H 01 J 37/30, H 01 J 37/147, H 01 J 37/21**

(54) Implanteur d'ions à fort courant comprenant des plaques de déflexion électrostatique et des moyens de refocalisation magnétique.

(30) Priorité : 23.12.77 FR 7739059

(43) Date de publication de la demande :
11.07.79 (Bulletin 79/14)

(45) Mention de la délivrance du brevet :
15.12.82 Bulletin 82/50

(84) Etats contractants désignés :
CH DE FR GB NL

(56) Documents cités :
FR A 2 231 106
FR A 2 316 721
FR A 2 375 716
US A 3 588 717
US A 3 638 231
US A 3 786 359
IBM TECHNICAL DISCLOSURE BULLETIN,
vol. 18, no. 6, novembre 1975, pages 1 832-1 835.
New York.

(73) Titulaire : ANVAR Agence Nationale de Valorisation
de la Recherche
13, rue Madeleine Michelis
F-92522 Neuilly-sur-Seine (FR)

(72) Inventeur : Campian, Jean
37, Boulevard Garibaldi
F-75015 Paris (FR)
Inventeur : Chaumont, Jacques
4, Square Arago
F-78330 Fontenay-le-Fleury (FR)
Inventeur : Meunier, Robert
9, Chemin à Dieu
F-78830 Bonnelles (FR)

(74) Mandataire : Mongrédien, André et al
c/o Brevatome 25, rue de Ponthieu
F-75008 Paris (FR)

# Implanteur d'ions à fort courant comprenant des plaques de déflexion électrostatique et des moyens de refocalisation magnétique

La présente invention, due aux travaux de Messieurs Jean CAMPLAN, Jacques CHAUMONT et Robert MEUNIER de l'Institut National de Physique Nucléaire et de Physique des Particules ($IN_2P_3$), a pour objet un implanteur d'ions à fort courant. Elle trouve une application dans la réalisation d'implanteurs ioniques destinés notamment à la fabrication de semiconducteurs.

On sait que, dans le domaine du dopage de matériaux, la technique d'implantation ionique offre de nombreux avantages par rapport aux techniques de diffusion et d'épitaxie. Elle consiste essentiellement à produire des ions des groupes III ou V de la classification périodique et à les diriger sur le matériau à traiter. Cette technique ne donne toutefois de bons résultats que si l'on parvient à surmonter une difficulté qui est celle de l'obtention d'une implantation uniforme. Les implanteurs ioniques comprennent donc en général des moyens permettant d'obtenir cette uniformité. Ils sont de natures différentes selon que l'implanteur appartient à la catégorie des appareils à faible ou moyen courant ou à la catégorie des appareils à fort courant. La frontière entre ces deux catégories dépend de la masse et de l'énergie des ions, mais est généralement située aux alentours de 0,5 mA.

Dans les implanteurs à faible courant, on connaît deux moyens de balayage permettant d'obtenir l'uniformité recherchée. Le premier est constitué généralement par deux jeux de plaques sur lesquelles on applique des tensions triangulaires, avec une fréquence de l'ordre du kilohertz ; les plaques d'un jeu sont perpendiculaires aux plaques de l'autre jeu afin que l'on puisse dévier le faisceau ionique dans deux directions perpendiculaires. Il s'agit donc d'un balayage électrostatique en XY. Le second fait appel à un balayage hybride électrostatique-mécanique : la surface en cours d'implantation est déplacée régulièrement et perpendiculairement à la direction d'un balayage de nature électrostatique.

A ces deux moyens de balayage que l'on rencontre donc dans les implanteurs à faible ou moyen courant, s'ajoute souvent un tube d'accélération additionnelle destiné à augmenter l'énergie des ions, ce tube pouvant être associé à un suppresseur d'électrons disposé en aval et qui est destiné à éviter l'accélération d'électrons secondaires à travers le tube d'accélération et par conséquent, à limiter la production de rayons X ; peuvent s'ajouter également des moyens d'analyse des ions aptes à sélectionner les ions désirés ; ces implanteurs peuvent comprendre en outre des moyens de refocalisation de nature électrostatique, ainsi que des moyens de déflexion du faisceau destinée à éliminer les neutres et enfin, une électrode repousseuse d'électrons disposée à proximité de la cible et destinée à permettre une mesure correcte du courant.

Pour tout ce qui concerne ces différents moyens, on pourra se reporter, par exemple, au rapport de J. H. FREEMAN, publié dans Atom GB 05 : 8147, Scientific Administration AERE Harwell, Oxfordshire GB ou à l'article de D. AITKEN intitulé « The Design Philosophy for a 200 kV Industrial High Current Ion Implanter », publié dans la revue « Nuclear Instruments and Methods » 139 (1976), 125-134, ou encore à l'ouvrage de G. DEARNALAY intitulé « Ion Implantation » North-Holland Publishing Company, Amsterdam-London, 1973.

Pour les deux systèmes de balayage, soit purement électrostatique, soit hybride électrostatique-mécanique, le contrôle de la dose implantée (qui est le produit de l'intensité du courant ionique par la durée d'irradiation) est simple à effectuer. A cause du grand nombre de passages du faisceau sur les échantillons, il est facile de déterminer la fin de l'irradiation, qui a lieu après un temps minimum qui n'est pas long. En outre, ce grand nombre de passages permet d'éliminer les inévitables problèmes de fluctuations d'intensité du faisceau (claquages ou autres), les durées des perturbations engendrées étant toujours grandes devant la plus petite des deux périodes de balayage.

Mais ces deux moyens de balayage, s'ils conviennent bien pour les faibles ou moyens courants, sont réputés inutilisables dans les implanteurs à fort courant. On admet, en effet, dans l'art antérieur, que pour les appareils à fort courant, les moyens électrostatiques de déflexion ne peuvent plus être utilisés en raison de l'importance que prend alors le phénomène de charge d'espace. Dans ses grandes lignes, ce phénomène est le suivant. Dans un faisceau ionique intense, les forces de répulsion d'origine électrique sont telles qu'elles ont tendance à faire éclater de faisceau. Mais cet effet est compensé par la présence, au sein du faisceau, d'électrons de faible énergie qui proviennent des collisions entre ions et atomes neutres du gaz, ou du bombardement des parties solides de l'installation. Le faisceau d'ions peut être totalement neutralisé par la présence de ces électrons, à condition toutefois que les éventuelles fluctuations en intensité du faisceau soient de faible amplitude ou de basse fréquence.

Si l'on tente de modifier la trajectoire d'un faisceau ionique neutralisé par des moyens de nature électrostatique, on perturbe du même coup la population d'électrons présente dans le faisceau, de sorte que la neutralisation du faisceau s'en trouve affectée. Le faisceau n'étant plus complètement neutralisé, son maniement soulève alors des difficultés.

C'est la raison pour laquelle on admet, dans l'art antérieur, que les systèmes de balayage de nature électrostatique sont inappropriés aux implanteurs ioniques à fort courant. C'est ce qui est affirmé en particulier par D. AITKEN dans l'article déjà cité et par W. C. KO dans l'article intitulé « High-Current Electric Scanning Method for Ion Bean Writing » publié dans la revue IBM Technical Disclosure Bulletin, vol. 18, n° 6, Nov. 1975, p. 1 832 à 1 835.

Les sytèmes à balayage électrostatique ou à balayage hybride électrostatique-mécanique ont donc dû être abandonnés pour ces implanteurs à fort courant et des systèmes à balayage purement mécanique ont alors été mis au point. Ils consistent par exemple, à maintenir fixe la zone d'impact du faisceau et à déplacer les échantillons dans cette zone. Ce déplacement peut être obtenu par un ou plusieurs tambours sur lesquels s'enroule une bande transporteuse d'échantillons. Ces tambours sont animés d'un double mouvement, l'un de rotation autour de l'axe et l'autre de translation parallèlement à cet axe. Ces deux mouvements combinés donnent à chaque échantillon une trajectoire en hélice.

La vitesse de rotation des tambours est, par exemple, de 80 t/mn et la translation de la bande parallèlement à l'axe des tambours est d'environ 1 mm par tour. Si la bande transporteuse présente une largeur de 200 mm et la zone d'impact une hauteur de 50 mm, l'amplitude totale du déplacement latéral de la bande doit être de 250 mm, ce qui nécessite 250 tours.

De tels systèmes à balayage purement mécanique présentent plusieurs inconvénients :

1. en raison de la faible vitesse de translation du tambour, le nombre de tours effectué par celui-ci doit être entier et prédéterminé en fonction de l'intensité du faisceau ;

2. comme, en pratique, l'intensité du faisceau subit des fluctuations lentes, celles-ci devront être compensées, soit en asservissant l'intensité du faisceau aux déplacements du tambour, soit inversement en asservissant ces déplacements à l'intensité. On conçoit que de tels moyens soient très complexes et de mise en œuvre délicate ; ils peuvent même nécessiter l'emploi d'un ordinateur. Ils sont décrits dans les articles de AITKEN et de FREEMAN cités plus haut.

Si ces deux inconvénients peuvent être surmontés, il en est d'autres cependant qui restent insurmontables :

3. dans le cas d'un balayage mécanique, les périodes de balayage étant au moins cent fois plus grandes que les périodes de balayage électrostatique, la condition indiquée plus haut, selon laquelle la durée des fluctuations doit être inférieure à la plus petite des durées des balayages, ne peut plus être satisfaite. Si l'on voulait remédier à cet inconvénient, il faudrait avoir recours à des durées d'implantation très longues qui seraient inacceptables dans la pratique et à un abaissement de l'intensité du faisceau ionique, ce qui ramènerait alors au domaine des implanteurs à faible courant ;

4. la température de la surface de la cible et le réarrangement partiel du réseau cristallin de celle-ci sont directement liés à la durée pendant laquelle le faisceau irradie une même partie de la cible. Avec le balayage mécanique, cette durée est longue et ces problèmes deviennent insurmontables pour certains processus de fabrication.

Des moyens de balayage de nature magnétique ont alors été proposés, mais ils se heurtent encore à cette difficulté de ne pas permettre d'atteindre des fréquences de balayage élevées.

Pour obtenir, dans un implanteur ionique à fort courant, une vitesse de balayage rapide, on est donc contraint de revenir au balayage électrostatique, mais cela implique que l'on sache mettre en œuvre des moyens aptes à surmonter les difficultés qui naissent alors de la non-neutralisation de la charge d'espace.

Dans ce but, il a été proposé d'appliquer un champ magnétique dans l'espace de déflexion électrostatique, ce champ étant perpendiculaire au champ électrique de balayage et à l'axe du faisceau. Ce champ oblige les électrons à osciller le long de l'axe du faisceau ionique avec le champ électrique de balayage et permet, en quelque sorte, de retenir, entre les plaques de déflexion, les électrons dans le faisceau. On pourra se reporter à ce sujet à l'article de W. C. KO déjà cité. Mais cette solution est onéreuse et de mise en œuvre délicate.

Par ailleurs, la demande de brevet français FR-A-2 316 721 décrit un implanteur d'ions à fort courant utilisant des plaques de déflexion électrostatique. Cet appareil comprend un ou plusieurs jeux de plaques de déflexion horizontales et verticales. A chaque jeu de plaques de déflexion correspond une paire de portes, portes qui sont placées respectivement à proximité du bord avant et arrière des plaques de déflexion. Les portes sont excitées par une tension négative suffisamment élevée afin d'empêcher les électrons de pénétrer dans la région définie entre les plaques de déflexion et les portes. Par voie de conséquence, les électrons ne peuvent pas former un nuage autour de la plaque de déflexion polarisée positivement.

Dans un tel dispositif, on agit donc encore sur les électrons dans le volume de déflexion.

Enfin, il faut observer que l'utilisation de moyens magnétiques, particulièrement de quadrupôles magnétiques ou de lentilles magnétiques, est connue pour influencer les trajectoires des faisceaux de particules chargées.

La présente invention propose une autre solution plus simple et moins onéreuse, qui permet de conserver la rapidité inhérente au balayage électrostatique tout en surmontant les difficultés dues à la non-neutralisation de la charge d'espace. L'implanteur de l'invention évite alors les inconvénients cités plus haut à propos des appareils à balayage mécanique. Il permet en particulier de travailler avec des durées d'irradiation brèves, ce qui évite les problèmes d'élévation de température de la surface de la cible et de réarrangement du réseau cristallin. L'implanteur de l'invention devient donc apte à tous les processus de fabrication, ce qui lui confère une grande valeur commerciale.

De façon précise, la présente invention a pour objet un implanteur d'ions à fort courant, dû

genre de ceux qui comprennent, dans une enceinte à vide, une source d'ions, des moyens d'extraction de ces ions, des moyens de balayage électrostatique constitués par des plaques de déflexion reliées à une source de tension appropriée et une cible porte-échantillons, caractérisé en ce qu'il comprend en outre un moyen magnétique réglable de refocalisation disposé à proximité desdites plaques.

Il s'agit par exemple d'un ou de plusieurs quadrupôles magnétiques ou d'une ou de plusieurs lentilles magnétiques. Ce moyen magnétique de refocalisation est placé de préférence en amont des plaques déflectrices.

Les différences principales entre la dispositif de l'invention et ceux de l'état de la technique sont donc les suivantes : alors que dans les dispositifs de l'art antérieur, pour réduire le phénomène de défocalisation, on prévoit des moyens pour agir sur les électrons dans le volume de déflexion, dans l'objet de l'invention on agit sur le faisceau d'ions pour provoquer sa refocalisation, et cela en dehors du volume de déflexion.

Le moyen de balayage électrostatique impose un déplacement du faisceau. Ce déplacement doit se faire à une vitesse telle que toutes les parties des cibles reçoivent la même dose quel que soit l'angle sous lequel le faisceau les atteint (angle d'incidence). Si cet angle est faible, il suffit que cette vitesse soit constante, donc que la tension de balayage soit de type triangulaire. Si au contraire, cet angle devient important, cette tension peut être volontairement déformée pour compenser les inhomogénéités dues au grand angle d'incidence.

Le moyen magnétique présente l'avantage de ne pas introduire d'effet de charge d'espace. De plus, il peut compenser la défocalisation due à la non-neutralisation de la charge d'espace, en étant « surfocalisant ». On entend par là que son action sur le faisceau peut être telle qu'en l'absence de charge d'espace, ce moyen magnétique ferait converger le faisceau en amont de l'endroit désiré. Les effets surfocalisant du moyen magnétique et défocalisant de la charge d'espace se trouvent compensés.

Grâce à l'invention, l'image obtenue sur la cible a au moins une dimension réduite, ce qui autorise un balayage moins large de la cible et entraîne, par conséquent, une meilleure utilisation du faisceau.

De préférence, ce moyen magnétique est surfocalisant, avec les avantages inhérents à la surfocalisation, comme indiqué plus haut.

De toute façon, les caractéristiques et avantages de l'invention apparaîtront mieux après la description qui suit, d'exemples de réalisation donnés à titre explicatif et nullement limitatif, en référence aux dessins annexés sur lesquels :

la figure 1 représente un schéma général d'un implanteur d'ions à fort courant selon la présente invention,

la figure 2 représente de façon plus précise le système à plaques déflectrices combiné avec deux quadrupoles magnétiques.

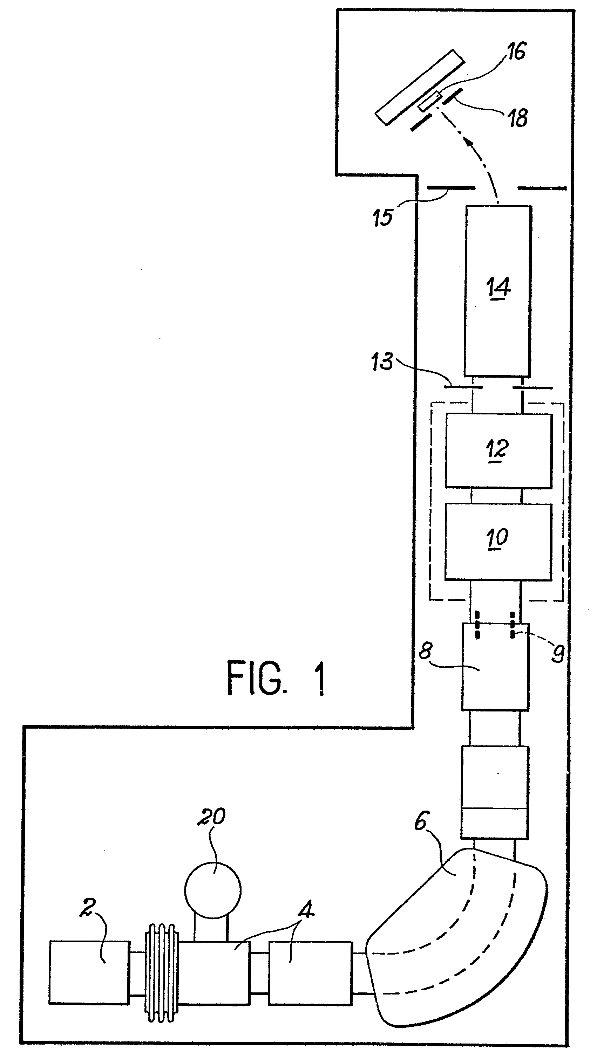

L'implanteur ionique représenté sur la figure 1 comprend successivement une source d'ions 2, un moyen d'extraction et de pré-accélération 4, un analyseur magnétique 6, un tube de postaccélération 8, éventuellement une électrode suppresseuse d'électrons 9, puis, selon l'invention, deux lentilles quadrupolaires magnétiques 10 et 12 suivies d'un système de déflexion électrostatique 14 inséré entre deux lentilles 13 et 15 et enfin, de manière connue, une cible 16 porte-échantillons à proximité de laquelle est disposée une électrode repousseuse d'électrons 18. L'installation est sous vide poussé grâce à des pompes dont une seule est représentée, qui porte la référence 20.

Tous les moyens représentés sur la figure 1 ne doivent pas nécessairement être utilisés conjointement, l'essentiel étant, selon l'invention, qu'un moyen magnétique de refocalisation 10/12 soit disposé à proximité (ici en amont) des moyens de balayage électrostatique 14.

L'angle d'incidence du faisceau sur la cible étant faible, la tension de balayage peut être triangulaire avec, par exemple, une tension de l'ordre de 7 kV crête à crête, modulée à 1 000 Hz, le défaut de linéarité des rampes étant le plus faible possible et, par exemple, inférieur à 1 %. Cette tension peut être distribuée de part et d'autre du potentiel de la masse de l'appareil. La tension triangulaire peut présenter une valeur moyenne positive ou nulle.

Bien que de nombreux moyens puissent être utilisés pour réaliser la partie mécanique du balayage, l'utilisation d'un barillet à axe sensiblement perpendiculaire aux plaques de déflexion semble avantageuse ; elle permet de disposer les échantillons sur la paroi intérieure du barillet de telle sorte qu'ils se trouvent plaqués sur celle-ci lors de la rotation de l'ensemble. La vitesse linéaire du barillet peut être de l'ordre de quelques centaines de mètres par minute.

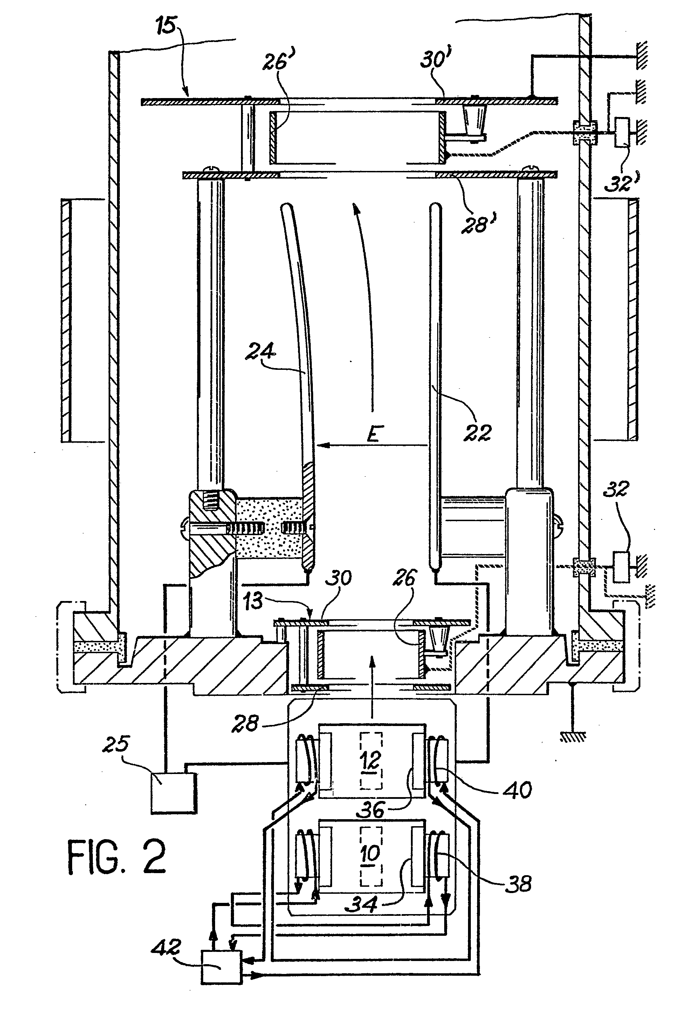

La figure 2 illustre un mode particulier de réalisation des moyens de l'invention. Dans la variante illustrée, chaque lentille est constituée par une électrode 26 (26') intercalée entre deux anneaux de garde 28 et 30 (28', 30'). L'électrode 26 (26') est reliée à la masse de l'appareil ou au pôle négatif ou positif d'une source de tension 32 (32') et les anneaux sont reliés à la masse. La tension délivrée par les sources 32 et 32' est par exemple de l'ordre de 300 V, mais peut atteindre quelques kilovolts.

Les anneaux de garde peuvent s'étendre jusqu'à proximité de l'enceinte extérieure de l'appareil, comme il est illustré sur la figure 2 pour l'écran aval.

Lorsque les lentilles sont reliées à la masse de l'appareil, la tension appliquée aux plaques 22 et 24 peut varier de part et d'autre de la masse, la valeur moyenne étant positive ou nulle. Dans l'exemple d'une tension crête à crête de 7 kV, cette tension peut varier de + 3,5 kV à − 3,5 kV.

Les quadrupoles magnétiques 10 et 12 peuvent être de tout type connu. Ils comprennent des pièces polaires 34 (36) alimentées en flux magnétique par des enroulements 38 (40) reliés à une double source de courant réglable 42.

A titre d'exemple nullement limitatif, on a utilisé avec succès des quadrupoles magnétiques dont les caractéristiques étaient les suivantes :

— longueur des pôles :             225 mm,

— diamètre du cercle inscrit à l'intérieur des pôles :             90 mm,

— gradient de champ magnétique :
             6 Teslas/m.

Avec un implanteur utilisant des ions d'arsenic et travaillant à une tension de 40 kV, le gradient de champ magnétique doit être pratiquement doublé lorsqu'on passe d'un courant de 100 µA à un courant de 2 mA.

Pour régler la surfocalisation du faisceau d'ions, on peut avantageusement procéder comme suit. Dans une première variante, les moyens de balayage sont mis en fonctionnement et l'on règle le moyen de refocalisation pour obtenir un faisceau d'ions focalisé sur la cible. Dans une seconde variante, les moyens de balayage ne sont pas mis en fonctionnement et l'on règle le moyen de refocalisation pour obtenir un faisceau d'ions focalisé en avant de la cible. Dans les deux cas, l'effet de la charge d'espace se trouve compensé par la surfocalisation.

## Revendications

1. Implanteur d'ions à fort courant, du genre de ceux qui comprennent, dans une enceinte à vide, une source d'ions (2), des moyens d'extraction (4) de ces ions, des moyens de balayage électrostatique (14) constitués par des plaques de déflexion (22, 24) reliées à une source de tension (25) appropriée et une cible porte-échantillons (16), caractérisé en ce qu'il comprend en outre un moyen magnétique réglable de refocalisation (10, 12) disposé à proximité desdites plaques (22, 24).

2. Implanteur d'ions selon la revendication 1, caractérisé en ce que le moyen de refocalisation (10, 12) est disposé en amont des plaques de déflexion (22, 24).

3. Implanteur d'ions selon l'une quelconque des revendications 1 et 2, caractérisé en ce que le moyen magnétique de refocalisation (10, 12) est constitué par au moins un quadrupôle magnétique (34, 38 ; 36, 40) ou par au moins une lentille magnétique.

4. Implanteur d'ions selon l'une quelconque des revendications 1 à 3, caractérisé en ce que le moyen magnétique (10, 12) est surfocalisant.

## Claims

1. Apparatus for implanting strong-current ions of the type comprising, in a vacuum chamber, an ion source (2), an ion-accelerator (4), electrostatic scanning means (14) comprising by deflection plates (22, 24) connected to an appropriate voltage source (25), and a target sample-holder (16), characterized in that it also comprises a controllable magnetic refocussing means (10, 12) located near said plates (22, 24).

2. Ion-implanting apparatus according to Claim 1 characterized in that the refocussing means (10, 12) is located above the deflection plates (22, 24).

3. Ion-implanting apparatus according to either of Claims 1 and 2 characterized in that the magnetic refocussing means (10, 12) comprises at least one magnetic quadrupole (34, 38 ; 36, 40) or at least one magnetic lens.

4. Ion-implanting apparatus according to any one of Claims 1 to 3 characterized in that the magnetic means (10, 12) is superfocussing.

## Ansprüche

1. Vorrichtung zur Implantation von Ionen großer Stromstärke, von der Art welche in einer Vakuumkammer eine Ionenquelle (2), Mittel (4) zum Herausbringen dieser Ionen, Mittel (14) zum elektrostatischen Abtasten, welche von mit einer geeigneten Spannungsquelle (25) verbundenen Ablenkplatten (22, 24) gebildet sind, und einen eine Probe tragenden Auffänger (16) umfaßt, dadurch gekennzeichnet, daß ferner ein einstellbares magnetisches Mittel zur Wiederfokussierung (10, 12) vorgesehen ist, welches nahe den Platten (22, 24) angeordnet ist.

2. Vorrichtung zur Implantation von Ionen nach Anspruch 1, dadurch gekennzeichnet, daß das Mittel zur Wiederfokussierung (10, 12) stromaufwärts der Ablenkplatten (22, 24) angeordnet ist.

3. Vorrichtung zur Implantation von Ionen nach irgendeinem der Ansprüche 1 oder 2, dadurch gekennzeichnet, daß das magnetische Mittel zur Wiederfokussierung (10, 12) von mindestens einem magnetischen Quadrupol (34, 38 ; 36, 40) oder von wenigstens einer magnetischen Linse gebildet ist.

4. Vorrichtung zur Implantation von Ionen nach irgendeinem der Ansprüche 1 bis 3, dadurch gekennzeichnet, daß das magnetische Mittel (10, 12) überfokussierend ist.

0 002 990

FIG. 1

FIG. 2